# EUROPÄISCHE PATENTANMELDUNG

(11) **EP 2 261 971 A1**
(43) Veröffentlichungstag der Anmeldung: **15.12.2010**
(21) Anmeldenummer: 10008598.4
(22) Anmeldetag: 02.04.2008
(51) Int. Cl.: H01L 23/495, H01L 21/56

(54) **VERFAHREN ZUM HERSTELLEN EINES LEISTUNGSMODULS**

(30) Priorität: 30.04.2007 DE 102007020618
(62) Teilanmeldung aus: 08748729.4
(71) Anmelder: Danfoss Silicon Power GmbH, 24837 Schleswig (DE)
(72) Erfinder: Ulrich, Holger, 24589 Eisendorf (DE); Senyildiz, Teoman, 24837 Schlesig (DE); Eisele, Ronald, 24229 Surendorf (DE)
(74) Vertreter: Biehl, Christian

(57) **Zusammenfassung**

Verfahren zum Herstellen eines festen Leistungsmoduls mit den Schritten :
- Erzeugen eines einstückig Stanzgitters,
- Bestücken des Stanzgitters und Bonden entsprechender Verbindungen,
- Einbringen des derart bestückten Stanzgitters in ein Presswerkzeug,
- Fixieren des Stanzgitters im Werkzeug durch Fixationsstempel,
- Einpressen einer duroplastischen Pressformmasse in das Werkzeug unter Umhüllung des bestückten Stanzgitters,

wobei das Stanzgitter vor dem Stanzen auf der späteren Seite der Kühlung durch thermisches Spritzen mit einer dünnen Schicht von Keramikpartikeln aus Aluminiumoxid oder Aluminiumnitrid in einer Schichtdicke zwischen 20 und 100µm belegt ist.

## Beschreibung

Die Erfindung betrifft ein Verfahren zum Herstellen eines festen Leistungsmoduls mit den Verfahrensschritten des Oberbegriffs des Hauptanspruches.

Eine bekannte Ausführungsform von Leistungsmodulen besteht aus offenen Leistungshalbleitern, die direkt auf metallische Stanzgitter gelötet oder geklebt werden werden (sog. die-on-leadframe).

Die einzelnen Stanzgitter werden typischerweise von einem Kunststoffrahmen fixiert, der durch Umhüllungsspritzen (Transfer Molding) der in das Spritzwerkzeug eingelegten Stanzgitterteile erzeugt wird. Die Stanzgitterteile tragen innerhalb des gespritzten Rahmens die Bauelemente und außerhalb des Rahmens stellen die Anschlussfahnen der Stanzgitterteile die elektrische Verbindung der Baugruppe zu anderen Komponenten dar.

Die Stanzgitterteile solcher Leistungsmodule sind auf mehrere Ebenen verteilt und müssen elektrisch von einander isoliert sein und sind dadurch zwangsweise mehrteilig. Die unterste Ebene ist auf der Innenseite mit Halbleitern bestückt und die gegenüberliegende Metallseite des untersten Stanzgitters ist einer äußeren Kühlfläche zugewandt. Derartige Module besitze keine Substratplatte (z.B. keramische Leiterplatte DCB) oder gar eine Bodenplatte aus Kupfer zur Wärmespreizung.

Weiter muß berücksichtigt werden, dass Leistungshalbleiter beim Schalten der elektrischen Ströme Verlustleistungen generieren, die mit der Schaltfrequenz und der Umgebungstemperatur zunehmen.

Eine wichtiger Aspekt ist es daher, die entstehende Verlustleistung bestmöglich an einen äußeren Kühlpfad (z.B. luft- oder wassergekühlter Kühlkörper aus Aluminium) abzugeben.

Leistungsmodule, die eine direkte elektrische Verbindung zum Stanzgitter (Leadframe) aufweisen, müssen jedoch eine ausreichende elektrische Isolierung gegenüber dem äußeren Kühlpfad aufweisen. Zu diesem Zweck werden die Stanzgitterflächen mit einer Kunststoffhaut überzogen, deren Dicke sich nach der erforderlichen Isolationsspannung richtet (z.B. nach US 2004 0026 778). Für Niederspannungsanwendungen ist auch eine Lösung bekannt (WO 2005 017 970) in der eine spezielle Paste erforderlich ist, die durch Partikel einen Mindestabstand gewährleistet. Derartige Pasten sind leider relativ schlechte Wärmeleiter (∼1 W/mK) im Vergleich zu Keramiken (∼25 - 160 W/mK).

Ein besonderes Problem tut sich nun auf, wenn ein Leistungsmodul nach dem Stand der Technik mit Hilfe der isolierenden Paste auf den Kühlkörper geschraubt wird.

Die fehlende Substratplatte, bzw. fehlende Bodenplatte nimmt dem Modul die Steifigkeit zwischen den Anschraubpunkten, um in ausreichendem Umfang den Anpressdruck zu entfalten, der die Paste dünn auspresst.

Stanzrahmenmodule mit einem offenen Innenvolumen verhalten sich beim Anschrauben wie ein vielgelenkiges System von Streifen. Dies führt zu Kissenbildung der Wärmeleitpaste in der thermisch beanspruchten Mitte des Moduls. Die Dicke der Wärmeleitpaste in der Mitte ist wegen der mangelnden Steifigkeit häufig 3-4mal dicker als am Rand des substratlosen Moduls.

Aufgabe der Erfindung ist es, ein Verfahren anzugeben, um Leistungsmodule mit erhöhter Steifigkeit zu erzeugen, die auch einer Vielzahl von Erwärmungszyklen widerstehen und dabei auch mechanischen hohen Anforderungen, wie sie beispielsweise in der Kraftfahrzeugtechnik herrscht, gerecht werden.

Erfindungsgemäß wird dies durch ein Verfahren nach dem Hauptanspruch gelöst. Die Unteransprüche geben vorteilhafte Ausgestaltungen an.

Insbesondere wird durch Erzeugen zunächst eines Stanzgitters, dann durch Bestücken des Gitters mit den Halbleiterbausteinen und Erstellen der Bondverbindungen, nachfolgendes Einbringen dieses bestückten Standgitters in ein Presswerkzeug, Fixieren des Stanzgitters im Presswerkzeug durch Fixationsstempel und Umhüllen des Stanzgitters mit einer duroplastischen Pressformmasse in einem Pressschritt ein glasartig hartes Leistungsmodul erzeugt, das insbesondere dann, wenn die Pressformmasse den gleichen thermischen Ausdehnungskoeffizienten wie die Hauptbestandteile der eingeschlossenen Struktur aufweist.

Diese eingeschlossene Struktur bewahrt die Halbleiter und ihre dünnen Bondverbindungen vor allen thermischen Beschädigungen aber auch vor durch thermische Zyklen induziertem Kriechen einzelner Materialien. Das dominante Material wird bei Kupferstanzgittern Kupfer sein, es kann jedoch auch das Material der Wärmeleiterplatte sein, wenn diese aus einem anderen Material als Kupfer besteht.

Es ist bevorzugt, den thermischen Ausdehnungskoeffizienten der Pressformmasse durch Beigabe von sich nur geringfügig ausdehnenden Partikeln, z.B. bis zu einer Füllmenge von 80-90% eines SiO2 Pulvers einzustellen. D.h. wenn gewünscht kann weniger als 80 % Beimengung stattfinden, oder kann eine Beimengung von einem Teil eines Pulvers und einem anderen Teil eines anderen Pulvers erfolgen. Auch können beide Pulver SiO2 sein oder enthalten, und sich nur in der/den Partikelgröße(n) unterscheiden. Es können auch zur Einstellung der Festigkeit bestimmte Partikelgrößenverteilungen vorgesehen werden.

Die Pressformmasse kann jedoch auch mit einem thermischen Ausdehnungskoeffizienten zwischen den beiden zweier Hauptmaterialien des Leistungsmoduls, die vorteilhafterweise nah aneinander gewählt sind, hergestellt werden, wobei der thermische Ausdehnungskoeffizient beispielsweise durch den Zusatz von niedrigausdehnendem Siliziumoxidpulver sehr genau in seiner Wärmeausdehnung eingestellt werden kann. Durch Beimengung bestimmter Partikelgrößenverteilungen kann zudem die Flexibilität der Pressformmasse vor und nach dem Pressen - im Endzustand - noch eingestellt werden.

Sofern lediglich sehr kleinteilige Partikel, beispielsweise Pulver, zugefügt wird, ergibt sich eine noch ein wenig flexible Pressformmasse, während dann, wenn verschiedene Korngrößen oder lediglich große Korngrößen zugefügt werden, betonartige Festigkeiten erreicht werden.

Vorteilhafterweise wird das Pressformen mit einem Druck von 150-250 bar vorteilhafterweise 200-210 bar durchgeführt, wobei Temperaturen im Bereich von 150-220 Grad, vorteilhafterweise 175-185 Grad eingehalten werden, was deutlich unterhalb der für einen Halbleiter Schaden verursachenden Temperaturen liegt.

Die Fixationsstempel sind vorteilhafterweise in dem Werkzeug in entsprechenden Führungen fest verankert und sollten zur Wiederverwendung rechtzeitig vor dem Erkalten der Pressformmasse wieder zurückgezogen werden, wodurch sich Löcher in der Umkleidung des Leistungsmoduls einstellen, durch die Trennstempel das Stanzgitter in einzelne Inseln aufteilen können, sofern die Fixationsstempellöcher mit einem Durchmesser größer als die Breite der zu durchtrennenden Leiterbahnen gestaltet sind. Weiterhin wird bevorzugt darauf zu achten sein, dass eine blanke Fläche des Leistungsmoduls beim Pressen verbleibt, an der Wärmeableitung der Halbleiter nach außen erfolgen kann.

Für den Fall, dass die Fixationsstempel nicht schon aus der noch teilflüssigen duroplastischen Pressformmasse gezogen werden, so dass die nachpressende Masse die Kanäle wieder schließt, können die entstandenen Löcher durch Vergießen gefüllt werden, um so den Umhüllungskörper zu vervollständigen und den Abschluss der Halbleiter zu gewährleisten.

Weitere Ausführungsbeispiele bestehen beispielsweise in den folgenden Varianten :
a. In einer besonderen Ausprägung der Erfindung kann das Stanzgitter vor dem Stanzen auf der späteren Seite der Kühlung mit einem bekannten Verfahren des thermischen Spritzens mit einer dünnen Schicht von Keramikpartikeln belegt werden. Geeignete Werkstoffe sind Aluminiumoxid oder Aluminiumnitrid. Geeignete Schichtdicken sind z.B. zwischen 20 und 100µm. Diese gut wärmeleitende Keramikschicht (ca. 25 -160 W/mK gegenüber ca. 1 W/mK für eine übliche Wärmeleitpaste z.B. Dow Corning Thermal Compound 340) steht durch das gewählte Verfahren in stoffschlüssiger Verbindung mit dem Stanzgitter und durch den nun möglichen hohen Montagedruck in formschlüssigen Kontakt mit dem äußeren Kühlkörper. Dadurch ist eine besonders gute Wärmeleitung vom Halbleiter über das Stanzgitter und der Keramikschicht zum Kühlkörper ermöglicht.
b. In einer weiteren Ausführungsform ist das Beschichten mit einer keramischen Funktionsschicht durch thermisches Spritzen auch nach dem Umhüllen des Stanzgitters möglich. Dann wird in dem Beschichtungsprozess nur die Seite des Modulkörpers mit Keramik versehen, die über die freiliegenden Stanzgitterflächen zur Kühlung benutzt wird.
c. Als eine Variante der Fügetechnik für die Halbeiter wird an Stelle der Weichlötung eine Niedertemperatur-Drucksinterung vorgeschlagen, die eine erheblich gesteigerte Scherfestigfestigkeit von Silizium (thermische Dehnung 3ppm/K) auf Kupfer (thermische Dehnung 18 ppm/K) gewährleistet. Diese Lösung ist besonders kostengünstig, weil eine Reinigung der Flussmittelreste einer Lötung entfällt.
d. Eine weitere Ausführung ist die Verwendung der durchstanzten Öffnungen (zur Beseitigung der Fixierstege der Inseln) als Durchführungsöffnungen für Montageschrauben. Zu diesem Zweck wird eine isolierende Hülse (zusätzlich als Feuchteschutz eingeklebt) zusammen mit der Schraube in die Öffnung eingeführt. Hintergrund: Inseln und die nötigen Durchstanzlöcher sind vorzugsweise im inneren Bereich der Modulfläche. Dieser innere Bereich (zentrumsnah) ist auch die Fläche höchster Erwärmung.

Ein Anpressen des Moduls durch Anschrauben bewirkt besonders rund um die Schraubendurchführung die höchsten Presskräfte und damit die geringste resultierende Schichtdicke einer thermischen Leitpaste. Die zentrumsnahe Montage durch die ohnehin vorhandenen Stanzlöcher erzeugt also eine zusätzliche Verbesserung der Entwärmung des Moduls. Weitere Bereiche für Montagelöcher (außerhalb des Stanzgitterbereichs im Umhüllungskörper) können also entfallen. Dies reduziert das Volumen und damit Kosten der Formpressmasse.
e. In einigen Anwendungen von Leistungsmodulen ist die äußere elektrische Kontaktierung mit Bondrähten gefordert. Das sichere Bonden von Aluminium-Dickdrähten wird vorzugsweise auf Aluminium durchgeführt. Es ist Stand der Technik, dass diese Bereiche auf dem Stanzgitter durch Walzplattieren mit einer dünnen Schicht Aluminium belegt werden. So kann auch das gewählte Stanzgitter im Bereich der inneren und äußeren Bondflächen mit einer vorzugsweise streifenartigen Aluminiumschicht ausgestattet sein.
f. Wie e., jedoch ist die Schicht Aluminium für dem Stanzen des Stanzgitters durch einen geeigneten Kleber mit dem Stanzgitter verbunden und bildet so einen Schichtverbund an den Orten wo eine Bondverbindung entstehen muss. Bei anteilig kleinen Aluminiumflächen ist dies eine kostengünstige Alternative zum Walzplattiern (wird in großen längen in Streifen durchgeführt, Inseln von Aluminiumflächen sind in Walzplattiertechnik nicht möglich)

Weitere Merkmale und Vorteile der Erfindung ergeben sich aus nachfolgender Beschreibung eines bevorzugten Ausführungsbeispiels. Dabei zeigt:
- Fig. 1: ein einstückiges und einlagiges Stanzgitter vor der Bestückung,
- Fig. 2: einen Schaltplan für eine B6-Transistorbrückenschaltung
- Fig. 3: das Stanzgitter nach dem Auflöten der Leistungshalbleiter und etwaiger weiterer passiver Komponenten,
- Fig. 4: das Stanzgitter nach dem Schritt des Formpressens des unverän- derten, aber bestückten Stanzgitters,
- Fig. 5: das Leistungsmodul im Umhüllungskörper mit außen freigestanz- ten Kontaktflächen für den elektrischen Anschluss,
- Fig. 6: das Stanzgitter (ohne Umhüllung dargestellt) mit nach dem Ausstanzen der Stege durch stempelartige Stanzwerkzeuge erzeugten zwei Lacklöcher,
- Fig. 7: eine perspektivische Ansicht bei der Verwendung der durchstanz- ten Öffnungen (zur Beseitigung der Fixierstege der Inseln) als Durchführungsöffnungen für Montageschrauben, die mit ihren I- solationshülsen ebenfalls dargestellt sind, und
- Fig. 8: eine Schnittdarstellung bei der Verwendung von Platzhaltern.

Während Fertigungsschritte im eingangs beschriebenen Stand der Technik eine doppelte Umhüllungstechnik (Schritt 2 und Schritt 4 der nachfolgenden Liste) erzwingen, wird das Transistormodul nach der Erfindung in einem Schritt mit einem Stanzgitter und Halbleiterbausteinen in einer Umhüllung aus einer duroplastischen Pressformmasse verpresst.

Im Stand der Technik dagegen mussten die folgenden Schritte durchgeführt:
1. Löten der Halbleiter auf das Stanzgitter
2. Umspritzen eines Rahmens an das Stanzgitter zur Schaffung eines Innenvolumens für die interne Verdrahtung der Halbleiter
3. Herstellen aller erforderlichen Bondverbindungen innerhalb des Moduls
4. Füllen des Innenvolumens des Moduls mit einem dauerhaft weichem Silikonverguss (Softgel) zur Erzielung der elektrischen Isolation und Dämpfung von Schwingungen

Gegenüber dem Softgel, dessen Nachteile eingangs erläutert wurden, wird nun ein im allgemeinen sehr fester Körper geschaffen, dessen thermischer Ausdehnungskoeffizient den dominanten Bestandteilen des Leistungsmoduls durch entsprechende Beimengung gering sich ausdehnenden Materials vorbestimmter Körnungsverteilung eingestellt ist.

Das Verfahren zum Herstellen eines Leistungsmoduls mit den Schritten Erzeugen eines Stanzgitters, Bestücken des Stanzgitters mit Halbleiterbausteinen, etwaigen passiven Bauelementen und Bonden entsprechender Verbindungen, Einbringen des derart bestückten Stanzgitters in ein Presswerkzeug, Fixieren des Stanzgitters im Werkzeug durch Fixationsstempel, und Einpressen einer duroplastischen Pressformmasse in das Werkzeug unter Umhüllung des bestückten Stanzgitters ist dabei in der Erfindung einfach beherrschbar.

Die Fixationsstempel können vor einem Erhärten der Pressformmasse zurückgezogen werden, insbesondere jedoch, bevor die Pressformmasse eine innige Verbindung mit ihnen eingeht.

Dabei sollte das Fixieren des Stanzgitters im Werkzeug durch auf Verbindungsstege wirkende Fixationsstempel erfolgen, deren Breite größer als die Breite der Verbindungsstege ist und beim Fixieren durch Fixationsstempel eine Kühlfläche derart an die Seite des Werkzeuges gepresst werden, dass sie beim (teilweisen) Umhüllen nicht mit Pressformmasse beschichtet wird.

Durch die beim Zurückziehen der Fixationsstege entstehende Löcher in der Vergussmasse können schließlich - vor dem endgültigen Vergießen - Stanzstempel das bestückte Stanzgitter in mehrere elektrische voneinander getrennte Teilgitter zur Erzeugung mehrerer elektrisch getrennter Einrichtungen in dem Modulkörper auftrennen, und so ein weiteres, im Stand der Technik herrschendes Problem bei der Gestaltung von Leiterbahn-Inseln im Leiterbahnverlauf des Stanzgitters zu lösen. Stanzgitter sind stets untereinander verbundene Anordnungen von Leiterbahnzügen und Flächen für Halbleiter und andere Bauelemente. Inselstrukturen waren bisher nicht möglich, da allseitig freigestanzte Leiterflächen des Stanzgitters ohne Fixierung nicht ortsfest wäre. Dies erzwang Lösungen in verschiedenen Ebenen, mit den oben beschriebenen Nachteilen.

Es wird vorgeschlagen, mehrere Maßnahmen in Kombination zu verwenden:
1. Die Steifigkeit des Moduls kann durch das volumenmäßig vollständige Ausfüllen des Modulkörpers durch Formpressen (Transfer Molding) mit einem duroplastischen harten, glasartigen Polymerwerkstoff erfolgen (z.B. Henkel Loctite Hysol). Es entsteht eine so genannter Umhüllungskörper (Moldmodul). Zu diesem Zweck müssen die Fertigungsabläufe folgendermaßen neu strukturiert werden (siehe Liste unten). Dies führt zur Reduzierung der Fertigungsschritte gegenüber dem Stand der Technik, denn es gibt nur einen Vorgang der Volumenfüllung durch das Formpressen nach dem Drahtbonden.
2. Das Stanzgitter besteht aus nur einer einzigen und einstückigen Lage Leitmaterial, z.B. Cu. Die später notwendigen Inseln werden durch mindestens eine Verbindung mit dem Rest des Stanzgitters in Position gehalten. Typischerweise werden Inseln mit zwei oder drei Stegen stabilisiert. Es sind auch Lösungen möglich, bei denen ein Steg zwei spätere Inseln fixiert. Wenn im Laufe des Fertigungsprozesses das Einzel-Stanzgitter von der Formmasse umhüllt ist, wird die Leiterbahn-Insel zusätzlich durch die gehärtete Formmasse fixiert und kann nicht mehr die Position ändern. Die vom Stanzgitter zu trennenden (dann auch elektrisch isolierten) Inseln in der Leiterbahnführung entstehen erst nach dem Ausfüllen durch Formpressen. Zu diesem Zweck erhält der ausfüllte Umhüllungskörper Öffnungen, die durch entfernbare Stempel (rund oder eckig) während der Phase des Ausfüllens entstehen. Die Stempel sind Teil des Form-Werkzeuges und sind axial verschiebbar. Die entstehenden Öffnungen reichen von der Oberseite des Modulkörpers in das Innere des Moduls bis auf die Innenseite des Stanzgitters.

Während des Ausfüllens mit Formmasse drückt der Stempel also auf das noch ungetrennte Stanzgitter und fixiert es zusätzlich flächenbündig am Boden des Unterwerkzeuges und sorgt so für einen stufenlosen Übergang der Formasse zum außen sichtbaren Stanzgitter.

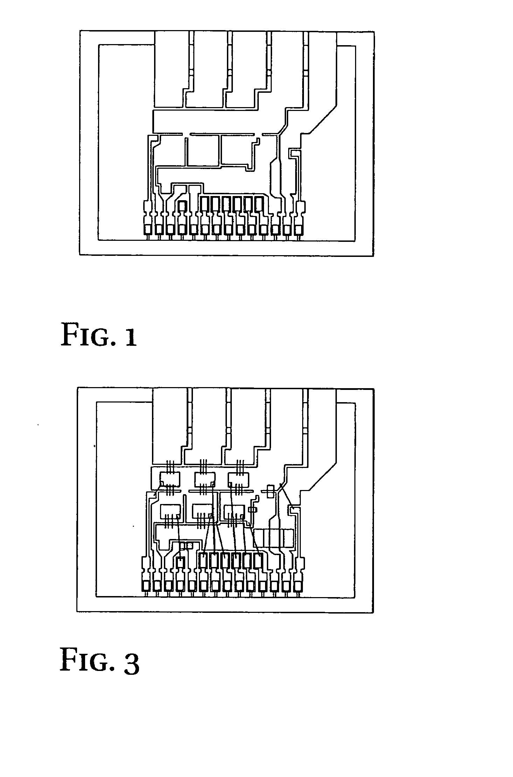

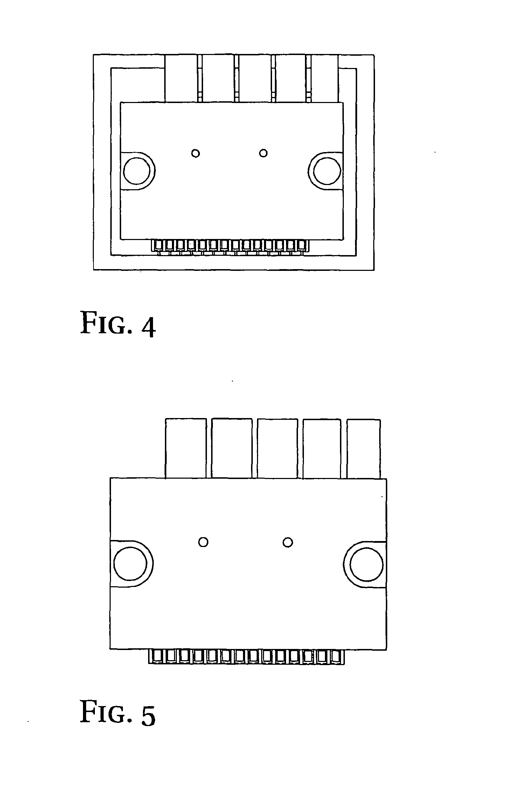

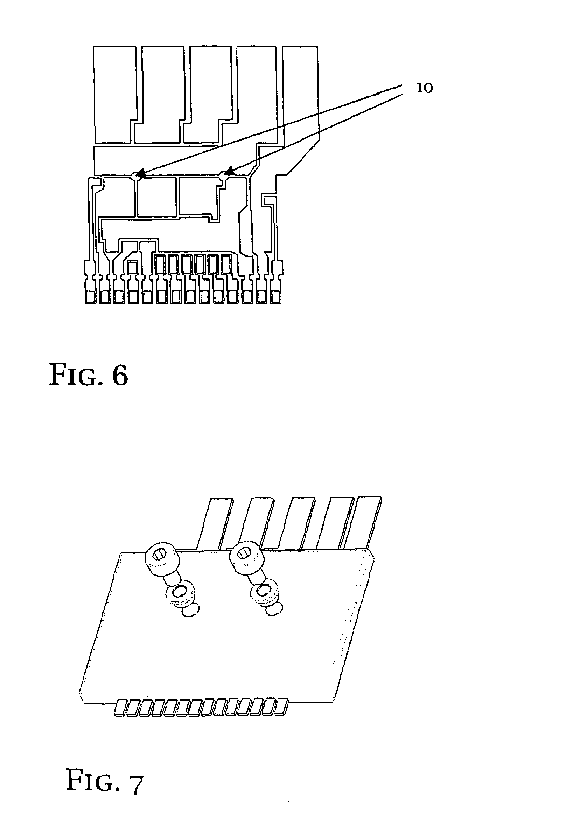

Auf diese Weise wird das so genannte Bleeding (allerdünnstes Unterlaufen der Metallflächen durch die Formpress-Masse) sicher vermieden und ein späteres Entfernen von den Wärmekontaktflächen kann entfallen. Nach dem Herausziehen der Stempel verbleibt das gewünschte Loch. In einem nachfolgenden Stanzschritt durchdringt ein Stanzstempel das vorgefertigte Loch vollständig und trennt das Stanzgitter am Orte der Öffnung. Die Stege sind getrennt und die Insel ist nun wie gewünscht elektrisch isoliert (Figur 4 + 6). Die Fertigungsschritte im Detail sind also:
- Löten der Halbleiter und weiterer Komponenten (Widerstände, Kondensatoren, Shunts auf das einstückige, einlagige und teilgestanzte Stanzgitter auf die vorbestimmten Positionen auf dem Stanzgitter (Figur 3)
- Herstellen aller erforderlichen Bondverbindungen innerhalb des Moduls auf dem Stanzgitter (Figur 3)
- Einlegen des bestückten Stanzgitters in das Werkzeug und Schließen des Unter- und Oberwerkzeuges
- Absenken der Fixierstempel auf die vorbestimmten Positionen auf dem Stanzgitter (das sind die später zu trennenden Verbindungsstege der späteren Inseln).
- Umhüllen des Stanzgitters, der Bonddrähte und Halbleiter mit Pressformmasse, deren thermischer Ausdehnungkoeffizient zum Material des Stanzgitters passt
- Herausziehen der Fixierstempel aus dem erstarrenden Umhüllungskörper
- Es verbleiben Löcher bis zur inneren Oberfläche des Stanzgitters (Figur 4)
- Die zur Bildung des Kühlpfades erforderlichen Flächen des Stanzgitters liegen flächenbündig und blank an einer Seite des umhüllten Modulkörpers.
- In einem Stanzschritt durchdringen geometrisch passende Stanzstempel an den Orten der vorbereiteten Öffnungen den Umhüllungskörper und trennen die Fixierstege der Insel(n) vom Rest der Leiterbahnzüge.
- Gegebenfalls erfolgt ein Vergießen der Löcher mit selbstbindenen Klebstoffen, um einen zusätzlichen Schutz vor Feuchte zu gewährleisten. Bei der Montage sind nun handelsübliche Wärmeleitpasten mit elektrisch isolierenden Fasern, Partikeln oder Geweben zur Erzeugung eines Mindestabstandes einsetzbar.

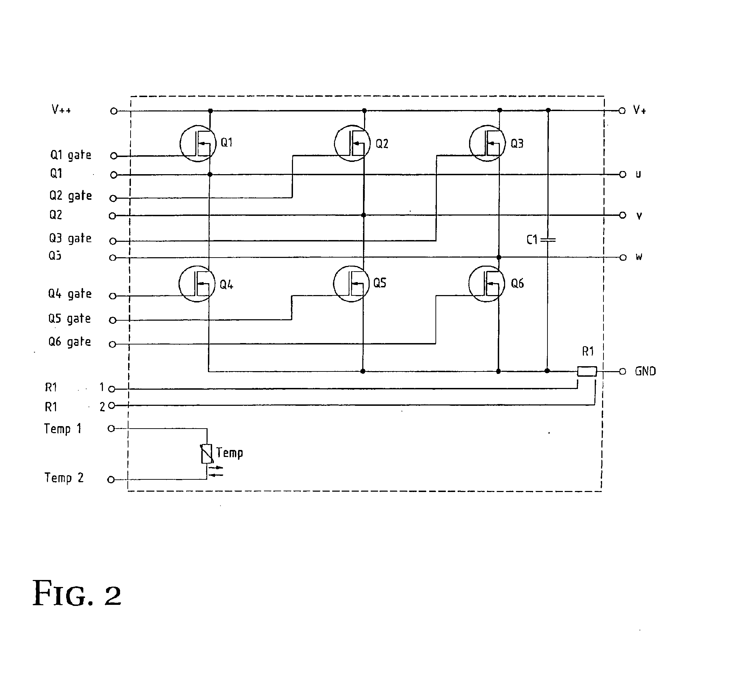

In der **Fig. 2** ist beispielhaft ein Schaltplan für eine B6-Transistorbrückenschaltung dargestellt. Die **Fig. 1** zeigt ein einstückiges und einlagiges Stanzgitter für eine solche B6-Transistorbrücke dargestellt. Alle benötigten Flächen sind noch durch ein oder mehrere Stege miteinander verbunden.

In **Fig. 3** ist der Fertigungsschritt des Auflötens der Leistungshalbleiter und weiterer passiver Komponenten (Thermistor, Widerstände, Kondensatoren, Shunts) bereits abgeschlossen. Anschließend wurden auf dem unveränderten Stanzgitter die notwendigen Drahtbondungen zur elektrischen Vollkontaktierung vorgenommen. In **Fig. 4** folgt der Fertigungsschritt des Umhüllens durch Formpressen des unveränderten, aber bestückten Stanzgitters. Der Umhüllungskörper hat durch die Gestalt des Werkzeuges seine äußeren Abmessungen erhalten und auf diese Weise auch zwei Löcher für die Aufschraubmontage. Die erwähnten, axialen Stempel im Werkzeug haben zwei Sacklöcher durch den Umhüllungskörper bis auf die Stanzgitteroberfläche hinterlassen (innere kleine Löcher).

**Fig. 5** zeigt das Leistungsmodul im Umhüllungskörper mit außen freigestanzten Kontaktflächen für den elektrischen Anschluß und **Fig. 6** das Stanzgitter, das nach dem Ausstanzen der Stege durch stempelartige Stanzwerkzeuge unterhalb der Sacklöcher entsteht. Damit sind die Inseln mechanisch und elektrisch von den anderen Stanzgitterflächen getrennt. Dies findet jedoch innerhalb des Umhüllungskörpers statt und ist so nicht sichtbar (es sei denn, man löst den Umhüllungskörper-Kunststoff chemisch auf und behält das Stanzgitter zurück). Es ist zu erkennen, dass die 2 durchstanzten Löcher insgesamt 4 Inseln erzeugen.

**Fig. 7** zeigt eine weitere Ausführung mit der Verwendung der durchstanzten Öffnungen (zur Beseitigung der Fixierstege der Inseln) als Durchführungsöffnungen für Montageschrauben. Zu diesem Zweck wird eine isolierende Hülse (zusätzlich als Feuchteschutz eingeklebt) zusammen mit der Schraube in die Öffnung eingeführt.

Das Freistanzen des bestückten, einstückigen Stanzgitters kann auch nicht durch Ausnehmungen hindurch, sondern durch vorher an den vorbestimmten Positionen eingefügte, fixierende Platzhalter-Körper erfolgen ("geopferte Niederhalter"). Diese fixierenden Platzhalter-Körper können aus einen Vollmaterial oder teilweise hohl sein und müssen die Bedingung erfüllen, dass sie von dem Freistanzwerkzeug durchdrungen bzw. verdrängt werden können (Elastomere).

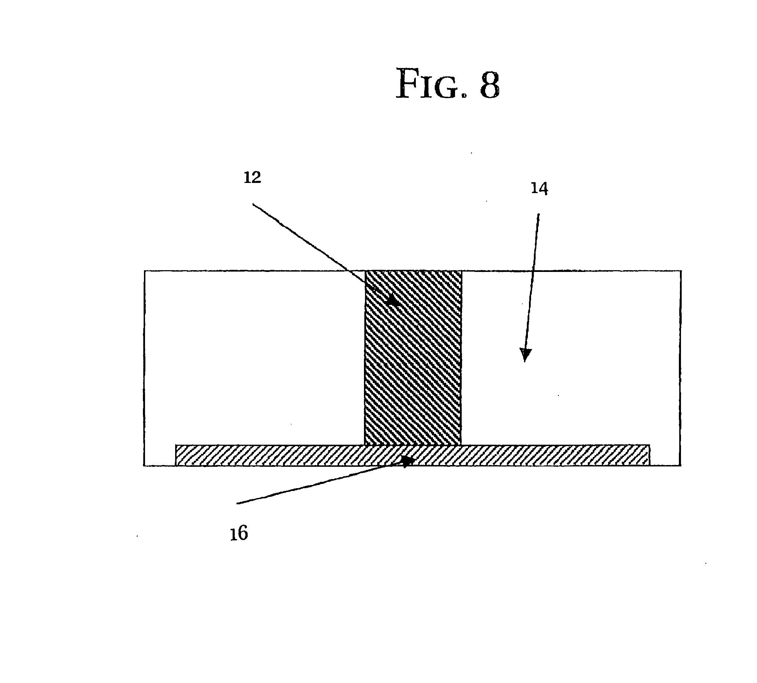

**Fig. 8** zeigt den Transitormodulkörper aus Pressmasse im Querschnitt. Dargestellt ist das noch einstückige Stanzgitter und ein Platzhalterkörper zum Fixieren des Stanzgitters im Werkzeug. Der Platzhalterkörper wird bereits während des Bestückvorgangs mit Bauteilen auf dem Stanzgitter plaziert und verdeckt die Verbindungsstege der später durch Freistanzen elektrisch zu isolierenden Inseln. Durch das Schließen der Werkzeughälften wird der Platzhalter-Körper zwischen Werkzeugwand und Stanzgitter eingeklemmt und fixiert daher das Stanzgitter in dem Werkzeug. Beim Einpressen der Pressformmasse bleibt in der Platzhalterkörper im Werkzeug und wird von Pressformmasse teilweise umgeben und darin fixiert. Damit sind die vorher beschriebenen werkzeuggeführten Stempel nicht erforderlich.

Das Werkzeug zum Freistanzen des vormalig einstückigen Stanzgitters durchdringt und verdrängt nun das Material des Platzhalter-Körpers, bis das Freistanzwerkzeug auf das Stanzgitter trifft und es durchtrennt. Für diesen Zweck ist es vorteilhaft, wenn der Platzhalter-Körper aus einem temperaturbeständigen und elastischen Material ist, welches zum einen die Einklemmfunktion im Werkzeug und zum anderen das Durchdringen und Verdrängen durch das Freistanzwerkzeug ermöglicht. Vorzugsweise handelt es sich dabei um ein Elastomer z. B. um Silikon.

Allgemein ist das Verfahren zum Herstellen eines Leistungsmoduls durch die Schritte: Erzeugen eines Stanzgitters, Bestücken des Stanzgitters mit Halbleiterbausteinen, etwaigen passiven Bauelementen und Bonden entsprechender Verbindungen, Einbringen des derart bestückten Stanzgitters in ein Presswerkzeug, Fixieren des Stanzgitters im Werkzeug durch Fixationsstempel, und Einpressen einer duroplastischen Pressformmasse in das Werkzeug unter Umhüllung des bestückten Stanzgitters beschrieben.

Es wird vorgeschlagen, daß das Stanzgitter einstückig ist, und beim Umhüllen Ausnehmungen an vorbestimmten Positionen verbleiben, so daß eine Zugänglichkeit des nicht umhüllten Stanzgitters gewährleistet ist, und nachfolgendes Heraustrennen von Stegen des einstückigen Stanzgitters durch die in die Ausnehmungen eingeführten Stanzstempel erfolgt, unter Erzeugung von elektrisch isolierten Inseln von Stanzgittermaterialien des vormals einstückigen Stanzgitters. Zur Herstellung der Ausnehmungen werden die Stempel vor einem Erhärten der Pressformmasse zurückgezogen.

Insbesondere werden die Stempel zurückgezogen werden, bevor die Pressformmasse eine innige Verbindung mit ihnen eingeht. Das Fixieren des Stanzgitters erfolgt im Werkzeug durch auf Verbindungsstege wirkende Stempel, deren Breite größer als die Breite der Verbindungsstege ist.

In die beim Zurückziehen der Fixationsstempel, entstehenden Löcher in der Vergussmasse können Stanzstempel eingeführt werden, die das bestückte Stanzgitter in mehrere elektrische voneinander getrennte Teilgitter zur Erzeugung mehrerer elektrisch getrennter Einrichtungen in dem Modulkörper auftrennen.

Alternativ kann das Freistanzen des bestückten, einstückigen Stanzgitters nicht durch Ausnehmungen hindurch, sondern durch vorher an den vorbestimmten Positionen eingefügte, fixierende Platzhalter-Körper erfolgen, so daß sich ein Transistormodul mit einem Stanzgitter und Halbleiterbausteinen in einer Umhüllung aus einer duroplastischen Pressformmasse, deren thermischer Ausdehnungskoeffizient den dominanten Bestandteilen des Leistungsmoduls durch entsprechende Beimengung gering sich ausdehnenden Materials vorbestimmter Körnungsverteilung eingestellt ist.

Dabei ist ein Transistormodul vorzuziehen, dass beim Fixieren durch Stempel bzw. durch die fixierenden Platzhalter-Körper eine Kühlfläche derart an die Seite des Werkzeuges gepresst ist, dass sie beim (teilweisen) Umhüllen nicht mit Pressformmasse beschichtet ist, und damit zu einem Teil der Außenfläche des Transistormoduls wird.

Weiter dienen die beim Freistanzen des vormals einstückigen Stanzgitters entstandenen Durchführungen im Transistormodulkörper zur Aufnahme von das Transistormodul mittels Schrauben oder Nieten auf einem Kühlkörper fixierender Elemente, so daß der Kühlkörper und das Transistormodul formschlüssig für einen optimalen Wärmetransport miteinander verbunden sind. Eine weitere Ausgestaltung bedient sich einer in die beim Freistanzen des vormals einstückigen Stanzgitters entstandenen Durchführungen im Transistormodulkörper eingesteckte, die metallischen Schrauben bzw. Nieten elektrisch isolierende Einsteck-Hülle.

## Patentansprüche

1. Verfahren zum Herstellen eines festen Leistungsmoduls mit den Schritten :
- Erzeugen eines einstückigen Stanzgitters,
- Bestücken des Stanzgitters und Bonden entsprechender Verbindungen,
- Einbringen des derart bestückten Stanzgitters in ein Presswerkzeug,
- Fixieren des Stanzgitters im Werkzeug durch Fixationsstempel,
- Einpressen einer duroplastischen Pressformmasse in das Werkzeug unter
Umhüllung des bestückten Stanzgitters,
**dadurch gekennzeichnet, daß**
das Stanzgitter vor dem Stanzen auf der späteren Seite der Kühlung durch thermisches Spritzen mit einer dünnen Schicht von Keramikpartikeln aus Aluminiumoxid oder Aluminiumnitrid in einer Schichtdicke zwischen 20 und 100µm belegt ist.¹

2. Leistungsmodul mit einer elektrisch isolierenden und thermisch gut leitenden, als Beschichtung aufgetragenen Schicht aus thermisch aufgespritzten miteinander verschmolzenen Partikeln aus Aluminiumoxid in einer Schichtdicke zwischen 20 und 100µm.

3. Leistungsmodul mit einer elektrisch isolierenden und thermisch gut leitenden, als Beschichtung aufgetragenen Schicht aus thermisch aufgespritzten miteinander verschmolzenen Partikeln aus Aluminiumnitrid in einer Schichtdicke zwischen 20 und 100µm.
